# DEMANDE DE BREVET EUROPEEN

(11) **EP 2 390 981 A1**
(43) Date de publication de la demande: **30.11.2011**
(21) Numéro de dépôt: 11354012.4
(22) Date de dépôt: 11.04.2011
(51) Int. Cl.: H02H 3/02, H02H 7/20

(54) **Dispositif de mise en sécurité d'une installation de génération d'énergie électrique et procédé de mise en oeuvre d'un tel dispositif**

(30) Priorité: 27.05.2010 FR 1002239
(71) Demandeur: Schneider Electric Industries SAS, 92500 Rueil-Malmaison (FR)
(72) Inventeur: Tarbouriech Laurent, 38050 Grenoble cedex 09 (FR); Vidalenche Gilles, 38050 Grenoble cedex 09 (FR)
(74) Mandataire: Picard, Laurent

(57) **Abrégé**

Dispositif de mise en sécurité (10) connecté un module de génération d'énergie électrique (20) via au moins deux première bornes de connexion (A1, A2) et connecté à un réseau électrique (30) via au moins deux secondes bornes de connexion (B1, B2). Le dispositif de mise en sécurité comporte des moyens de déconnexion (1, 2) électrique du module de génération d'énergie électrique et du réseau de distribution électrique (30). Les moyens de déconnexion comportent des premiers moyens interrupteurs (1) connectés en parallèle des premières bornes de connexion (A1, A2) et des second moyens interrupteurs (2) connectés en série entre les premières et secondes bornes. Des moyens de commande (3) comportent des moyens de désynchronisation de l'envoi des ordres de commande destinés aux premier et second moyens interrupteurs (1, 2).

## Description

### DOMAINE TECHNIQUE DE L'INVENTION

L'invention est relative à un dispositif de mise en sécurité d'une installation de génération d'énergie électrique destiné à être connecté un module de génération d'énergie électrique via au moins deux première bornes de connexion et destiné à être connecté à un réseau de distribution électrique via au moins deux secondes bornes de connexion. Le dispositif de mise en sécurité comportant des moyens de déconnexion électrique du module de génération d'énergie électrique et du réseau de distribution électrique.

L'invention est aussi relative à un procédé de commande d'un dispositif de mise en sécurité.

### ETAT DE LA TECHNIQUE ANTERIEURE

Les installations de génération d'énergie électrique comprenant par exemple des panneaux photovoltaïques ou des éoliennes peuvent présenter des risques dans certaines situations.

Par exemple, lorsque les pompiers interviennent pour l'extinction d'un incendie sur un bâtiment, les consignes de sécurité exigent de couper l'ensemble des fluides, y compris l'électricité pour assurer la sécurité des intervenants. Lorsque les pompiers coupent l'alimentation électrique du bâtiment, ils déconnectent le bâtiment du réseau électrique. Ainsi afin de respecter la norme, notamment la norme VDE0126, les convertisseurs électroniques des sources d'énergies stoppent la production électrique vers le réseau coté AC. Cependant, malgré cette deconnexion, les sources d'énergie autonomes telle que des panneaux photovoltaïques ou des éoliennes continuent de délivrer une tension électrique dangereuse pour la sécurité des personnes. Les lignes entre lesdites sources d'énergie autonomes et les convertisseurs restent donc sous tension. Il est difficile pour les pompiers d'arrêter et de mettre hors tension ces types de sources d'énergie car elles sont souvent très difficiles d'accès. En outre les moyens à déployer pour stopper la production d'électricité sont compliqués à mettre en oeuvre. En effet :
- il est nécessaire de masquer la lumière éclairant les panneaux photovoltaïques pour arrêter la génération d'une tension électrique issue desdits panneaux ;
- il est nécessaire de la bloquer mécaniquement une éolienne pour arrêter la génération d'une tension électrique issue de ladite éolienne.

Ces deux opérations ne peuvent pas être réalisées rapidement et simplement.

D'autres intervenants tels que les installateurs et les exploitants peuvent nécessiter de mettre l'installation en sécurité de façon urgente afin de protéger les personnes et/ou les matériels. La mise en sécurité de la ligne en aval directe de l'appareil de production est aussi utile pour une intervention de maintenance et d'entretien du matériel installé ou lors de l'installation.

La possibilité d'utiliser des disjoncteurs à courant continu commandés à distance pour couper les lignes en aval de l'appareil de production n'est pas exploitée. En effet, l'utilisation disjoncteur à courant continu fonctionnant sous une tension relativement élevée n'est pas répandue. En outre, ce type d'appareil de coupure présenterait l'inconvénient d'être de taille importante et d'être trop couteux par rapport au cout global d'une installation électrique. Pour toutes ces raisons, les installations de sources d'énergie autonomes sur des bâtiments résidentiels ne sont généralement pas équipées à ce jour de dispositif de mise en sécurité.

### EXPOSE DE L'INVENTION

L'invention vise donc à remédier aux inconvénients de l'état de la technique, de manière à proposer un dispositif de mise en sécurité d'une installation de génération d'énergie électrique.

Les moyens de déconnexion du dispositif de mise en sécurité selon l'invention comportent des premiers moyens interrupteurs connectés en parallèle des premières bornes de connexion et des seconds moyens interrupteurs connectés en série entre les premières et secondes bornes de connexion. Des moyens de commande d'ouverture et/ou de fermeture des premiers et second moyens interrupteurs comportent des moyens de désynchronisation de l'envoi des ordres de commande destinés aux premier et second moyens interrupteurs.

Selon un mode préférentiel de réalisation, les moyens de commande comportent des moyens de désynchronisation autorisant une temporisation de commande entre un premier ordre de commande de fermeture des premiers moyens interrupteurs et un second ordre de commande d'ouverture des seconds moyens interrupteur.

Avantageusement, les seconds moyens interrupteurs comportent au moins deux interrupteurs reliant respectivement au moins une première borne de connexion à au moins une seconde borne de connexion.

Selon un mode particulier de réalisation, les premiers moyens interrupteur comportent au moins deux interrupteurs connectés en série entre les premières bornes de connexion et étant commandé par les moyens de commande, un point commun entre lesdits au moins deux interrupteurs étant connecté à la terre pour autoriser une mise en court-circuit et une mise à la terre simultanée des premières bornes de connexion.

Le procédé de commande d'un dispositif de mise en sécurité tel que défini ci-dessus consiste à fermer les premiers moyens interrupteurs pour court-circuiter lesdites au moins deux premières bornes de connexion ; appliquer une temporisation et à ouvrir les seconds moyens interrupteurs pour interrompre toute liaison électrique entre le module de génération d'énergie électrique et le réseau de distribution électrique.

### BREVE DESCRIPTION DES FIGURES

D'autres avantages et caractéristiques ressortiront plus clairement de la description qui va suivre de modes particuliers de réalisation de l'invention, donnés à titre d'exemples non limitatifs, et représentés aux dessins annexés sur lesquels :
la figure 1 représente un schéma électrique du dispositif de mise en sécurité d'une installation de génération d'énergie électrique selon un premier mode de réalisation de l'invention ;
la figure 2 représente une vue schématique du dispositif de mise en sécurité d'une installation de génération d'énergie électrique selon un second mode de réalisation de l'invention ;
les figures 3A à 3C représentent des vues schématiques du dispositif de mise en sécurité selon la figure 1 dans différents états de fonctionnement ;

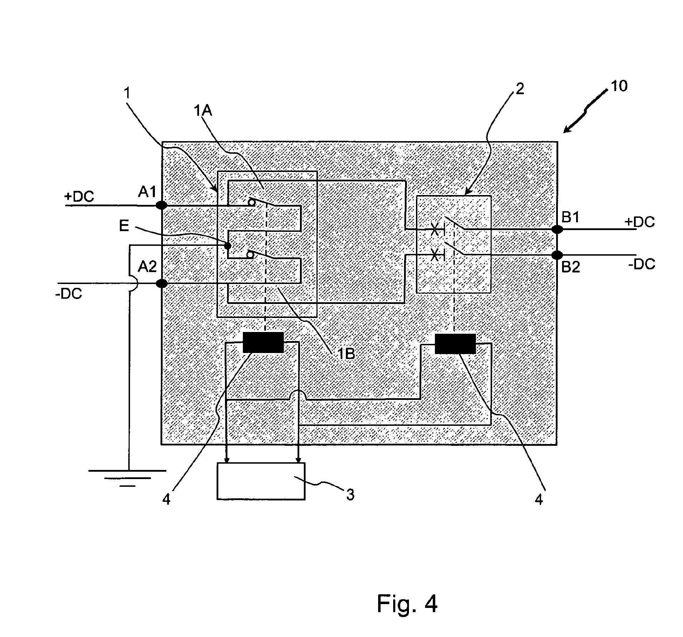

la figure 4 représente un schéma électrique d'un dispositif de mise en sécurité selon la figure 2 adapté à la protection d'une installation photovoltaïque ;

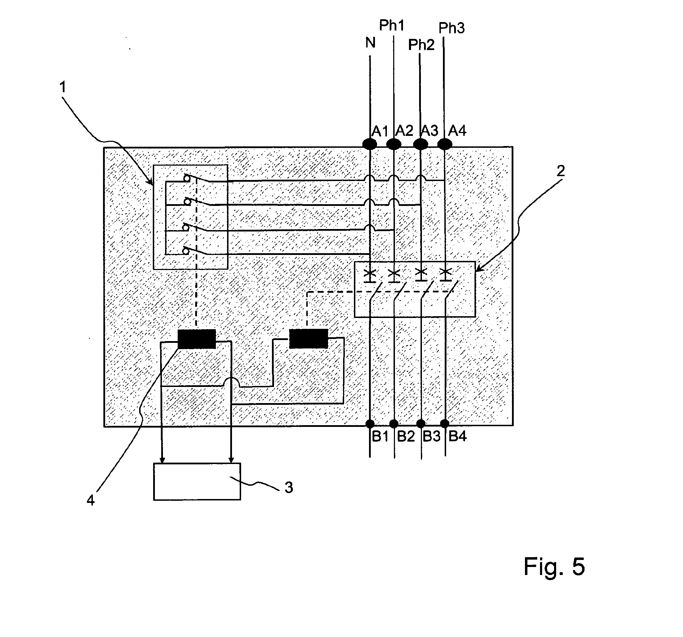

la figure 5 représente un schéma électrique d'un dispositif de mise en sécurité selon la figure 1 adapté à la protection d'une installation éolienne ;
la figure 6 représente un schéma électrique d'un dispositif de mise en sécurité selon la figure 2 adapté à la protection d'une installation éolienne.

### DESCRIPTION DETAILLEE D'UN MODE DE REALISATION

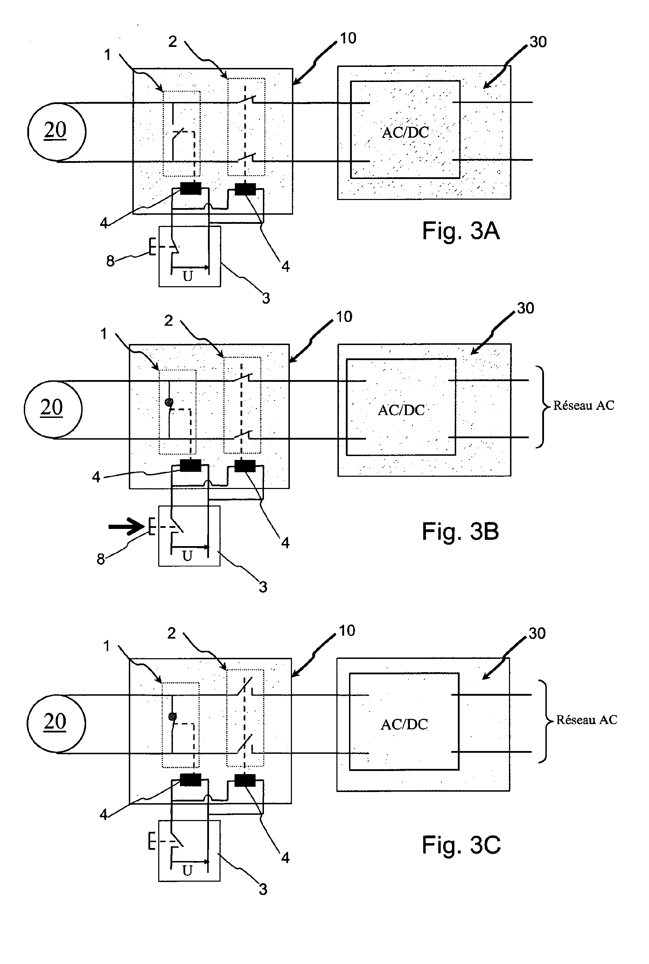

Selon un mode préférentiel de réalisation présenté sur les figures 3A, 3B et 3C, le dispositif de mise en sécurité 10 d'une installation de génération d'énergie électrique est destiné à être connecté un module de génération d'énergie électrique 20 via au moins deux première bornes de connexion A1, A2. En outre, ledit dispositif est destiné à être connecté à un réseau de distribution électrique 30 via au moins deux secondes bornes de connexion B1, B2.

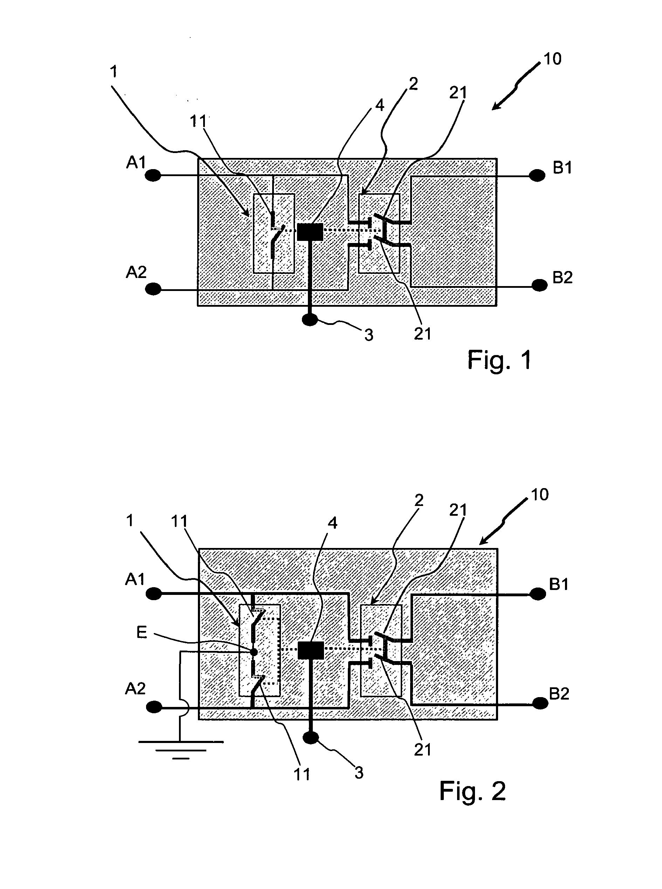

Le module de génération d'énergie électrique 20 peut comporter des panneaux photovoltaïques délivrant une tension continue. Comme représenté sur la figure 1, le dispositif de mise en sécurité 10 comporte alors deux premières bornes de connexion A1, A2 destinées à être connectées au module de génération 20 et comporte deux secondes bornes de connexion B1, B2 destinées à être reliées au réseau de distribution électrique 30. Un convertisseur DC/AC peut aussi être utilisé pour convertir la tension continue délivrée par les panneaux photovoltaïques en tension alternative.

Le module de génération d'énergie électrique 20 peut comporter au moins une éolienne délivrant une tension alternative triphasée. Le dispositif de mise en sécurité 10 comporte alors quatre premières bornes de connexion A1, A2, A3 et A4 destinées à être connectées au module de génération 20 et comporte quatre secondes bornes de connexion B1, B2, B3, B4 destinées à être reliées au réseau de distribution électrique 30.

Le dispositif de mise en sécurité 10 comporte des moyens de déconnexion 1, 2 électrique du module de génération d'énergie électrique 20 et du réseau de distribution électrique 30. Les moyens de déconnexion 1, 2 sont destinés à être reliés à des moyens de commande 3 commandant l'ouverture et/ou la fermeture desdits moyens de déconnexion 1, 2.

Selon un mode de réalisation de l'invention, les moyens de déconnexion comportent des premiers moyens interrupteurs 1 connectés en parallèle les premières bornes de connexion A1, A2, A3, A4. Selon un mode de développement particulier tel que représenté sur la figure 1, les premiers moyens interrupteurs 1 sont de préférence en position fermée lorsque le dispositif de mise en sécurité 10 est au repos notamment lorsque les moyens de commande 3 sont hors tension. En effet, pour des raisons de sécurité, le premiers moyens interrupteurs 1 sont de préférence fermés par défaut afin d'assurer la mise en court-circuit du module de génération d'énergie électrique 20 et mise à zéro de la tension au niveau du réseau de distribution électrique 30. A titre d'exemple de réalisation, les premiers moyens interrupteurs 1 comporte de préférence au moins interrupteur de type disrupteur 11.

Selon un mode de réalisation de l'invention, les moyens de déconnexion comportent des seconds moyens interrupteurs 2 connectés en série entre les premières et secondes borne de connexion A1, A2, A3, A4 - B1, B2, B3, B4. Selon un mode de développement particulier tel que représenté sur la figure 1, les seconds moyens interrupteurs 1 sont de préférence en position ouverte lorsque le dispositif de mise en sécurité 10 est au repos notamment lorsque les moyens de commande 3 sont hors tension. Chaque première borne de connexion A1, A2, A3, A4 est alors connectée en série à une seconde bonne de connexion B1, B2, B3, B4 via un contacteur 21. En effet, pour des raisons de sécurité, le seconds moyens interrupteurs 2 sont de préférence ouverts par défaut afin d'assurer une déconnexion du module de génération d'énergie électrique 20 par rapport au réseau de distribution électrique 30. A titre d'exemple de réalisation, les seconds moyens interrupteurs 1 sont de préférence des contacteurs 21.

Les premiers et seconds moyens interrupteurs 1, 2 sont commandés respectivement par des actionneurs 4 reliés aux moyens de commande 3.

Lorsque l'installation de génération d'énergie électrique est en fonction, c'est-à-dire que le module de génération d'énergie électrique 20 alimente le réseau de distribution électrique 30, les moyens de commande 3 sont sous tension et les premiers moyens interrupteurs 1 du dispositif de mise en sécurité 10 sont en position ouverte et les seconds moyens interrupteurs 2 sont en position fermée.

Selon un mode préférentiel de réalisation de l'invention, les moyens de commande 3 d'ouverture et/ou de fermeture des premiers et second moyens interrupteur 1, 2 comportent des moyens de désynchronisation de l'envoi des ordres de commande destinés aux premier et second moyens interrupteurs 1, 2. En effet, les moyens de commande 3 comportent des moyens de désynchronisation 4 autorisent une temporisation Δt entre l'envoi d'un premier ordre de commande de fermeture des premiers moyens interrupteurs 1 et un second ordre de commande de d'ouverture des seconds moyens interrupteur 2.

Ainsi, lorsque l'installation de génération d'énergie électrique est hors fonction, c'est-à-dire que le module de génération d'énergie électrique 20 ne doit pas alimenter le réseau de distribution électrique 30, les moyens de commande 3 ont fourni des ordres de commande de manière à placer les premiers moyens interrupteurs 1 en position fermée et les seconds moyens interrupteurs 2 en position ouvertes.

Selon tous les modes de réalisation de l'invention, le dispositif de mise en sécurité 10 est de préférence placé au plus près du module de génération d'énergie électrique 20 afin de réduire au maximum la longueur de ligne électrique sous tension lorsque l'installation de génération d'énergie électrique est hors fonction. Les moyens de commande 3 peuvent être déportés ou placés à proximité du dispositif de mise en sécurité 10. Une commande déportée 8 est alors facilement accessible aux pompiers, et à tout autre personne habilitée à déconnecter le module de génération d'énergie électrique 20 du le réseau de distribution électrique 30.

Selon une variante de réalisation telle que représentée sur les figures 3A - 3C, la commande déportée 8 comporte un bouton poussoir d'arrêt d'urgence, permet d'interrompre l'alimentation en tension des moyens de commande 3. Les moyens de commande 3 n'étant plus alimentés, l'installation de génération d'énergie électrique passe dans une hors fonction où les premiers moyens interrupteurs 1 sont en position fermée et les seconds moyens interrupteurs 2 en position ouvertes.

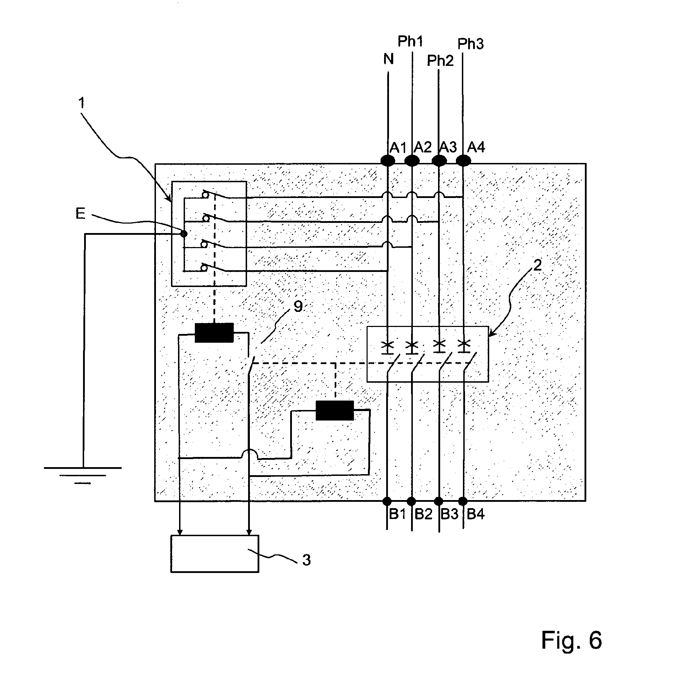

Selon un mode de développement particulier de l'invention tel que représenté sur les figures 2 et 6, les premiers moyens interrupteur 1 comportent au moins deux interrupteurs 11 connectés en série entre au moins deux premières bornes de connexion A1, A2. Lesdits au moins deux interrupteurs sont commandés par les moyens de commande 3. Un point commun E entre dits au moins deux interrupteurs est connecté à la terre pour autoriser une mise en court-circuit et une mise à la terre simultanée des premières bornes de connexion A1, A2 au moment de la fermeture des premiers interrupteurs 1A, 1B.

Selon une variante des modes de réalisation de l'invention telle représentée sur la figure 6, le dispositif de mise en sécurité 10 comporte un contacteur au ré-enclenchement 9. Ledit contacteur est destiné à conditionner l'ouverture du premiers moyens interrupteur 1 avec la fermeture manuelle des seconds moyens interrupteurs 2. Ce fonctionnement synchronisé des premiers et second moyens interrupteur 1, 2 permet d'éviter que la source 20 ne soit pas chargée.

L'invention est relative à un procédé de commande d'un dispositif de mise en sécurité 10 tel que défini ci-dessus. Comme représenté sur la figure 3B, le procédé consiste dans une première étape à fermer les premiers moyens interrupteurs 1 pour court-circuiter lesdites au moins deux premières bornes de connexion A1, A2. Le procédé consiste dans une seconde étape à appliquer une temporisation Δt. A titre d'exemple de réalisation, la temporisation est 200 ms. Comme représenté sur la figure 3C, le procédé consiste dans une troisième étape, à ouvrir les seconds moyens interrupteurs 2 pour interrompre toute liaison électrique entre le module de génération d'énergie électrique 20 et le réseau de distribution électrique 30. Les premières bornes de connexion A1, A2, A3, A4 ne sont plus alors reliées aux secondes bornes de connexion B1, B2, B3, B4 et l'installation de génération d'énergie électrique est alors hors fonction.

Selon une variante de réalisation du procédé de commande, le procédé consiste à fournir un ordre de commande pour placer l'installation de génération d'énergie électrique d'un état hors fonction dans un état en fonction. Le procédé consiste à fermer les seconds moyens interrupteurs 2 pour rétablir une liaison électrique entre le module de génération d'énergie électrique 20 et le réseau de distribution électrique 30. Les premières bornes de connexion A1, A2, A3, A4 sont alors reliées aux secondes bornes de connexion B1, B2, B3, B4. Le procédé consiste ensuite à ouvrir les premiers moyens interrupteurs 1 de manière à ce que le module de génération d'énergie électrique 20 alimente le réseau de distribution électrique 30.

## Revendications

1. Dispositif de mise en sécurité (10) d'une installation de génération d'énergie électrique destiné à être connecté un module de génération d'énergie électrique (20) via au moins deux première bornes de connexion (A1, A2, A3, A4) et destiné à être connecté à un réseau de distribution électrique (30) via au moins deux secondes bornes de connexion (B1, B2, B3, B4), dispositif de mise en sécurité comportant des moyens de déconnexion (1, 2) électrique du module de génération d'énergie électrique et du réseau de distribution électrique (30) ; les dits moyens comportant :
- des premiers moyens interrupteurs (1) connectés en parallèle des premières bornes de connexion (A1, A2, A3, A4) ;
- des seconds moyens interrupteurs (2) connectés en série entre les premières et secondes bornes de connexion (A1, A2, A3, A4 - B1, B2, B3, B4);
dispositif **caractérisé en ce que** les moyens de déconnexion comportent des moyens de commande (3) d'ouverture et/ou de fermeture des premiers et second moyens interrupteurs (1, 2) ; lesdits moyens de commande comportant des moyens de désynchronisation de l'envoi des ordres de commande pour autoriser une temporisation (Δt) de commande entre un premier ordre de commande de fermeture des premiers moyens interrupteurs (1) et un second ordre de commande d'ouverture des seconds moyens interrupteur (2).

2. Dispositif de mise en sécurité selon la revendication 1, **caractérisé en ce que** les seconds moyens interrupteurs (2) comportent au moins deux interrupteurs (21) reliant respectivement au moins une première borne de connexion (A1, A2, A3, A4) à au moins une seconde borne de connexion (B1, B2, B3, B4).

3. Dispositif de mise en sécurité selon l'une des revendications 1 ou 2, **caractérisé en ce que** les premiers moyens interrupteurs (1) comportent au moins deux interrupteurs (11, 12) connectés en série entre les premières bornes de connexion (A1, A2, A3, A4) et étant commandé par les moyens de commande (3), un point commun (E) entre lesdits au moins deux interrupteurs étant connecté à la terre pour autoriser une mise en court-circuit et une mise à la terre simultanée des premières bornes de connexion (A1, A2, A3, A4). *1B*).

4. Procédé de commande d'un dispositif de mise en sécurité (10) selon l'une quelconque des revendications précédentes, procédé caractérisé en qu'il consiste à :
- fermer les premiers moyens interrupteurs (1) pour court-circuiter lesdites au moins deux premières bornes de connexion (A1, A2, A3, A4) ;
- appliquer une temporisation (Δt) ;
- ouvrir les seconds moyens interrupteurs (2) pour interrompre toute liaison électrique entre le module de génération d'énergie électrique (20) et le réseau de distribution électrique (30).
